# EUROPÄISCHE PATENTSCHRIFT

(11) **EP 3 781 538 B1**
(45) Veröffentlichungstag und Bekanntmachung des Hinweises auf die Patenterteilung: **04.09.2024**
(21) Anmeldenummer: 19717489.9
(22) Anmeldetag: 12.04.2019
(51) Int. Cl.: C04B 35/58, C04B 35/645, C23C 14/06, C23C 14/34, H01J 37/34

(54) **TARGET UND VERFAHREN ZUR HERSTELLUNG EINES TARGETS**
TARGET AND METHOD FOR PRODUCING A TARGET
CIBLE ET PROCÉDÉ DE FABRICATION D'UNE CIBLE

(30) Priorität: 20.04.2018 AT 5007518 U
(43) Veröffentlichungstag der Anmeldung: 24.02.2021
(73) Patentinhaber: PLANSEE COMPOSITE MATERIALS GMBH, DE-86983 Lechbruck am See (DE)
(72) Erfinder: POLCIK, Peter, 86983 Lechbruck am See (DE); WOERLE, Sabine, 86983 Lechbruck am See (DE)
(74) Vertreter: Torggler & Hofmann Patentanwälte - Innsbruck
(86) Internationale Anmeldenummer: PCT/EP2019/059517
(87) Internationale Veröffentlichungsnummer: WO 2019/201796

(56) Entgegenhaltungen:
- WO-A1-2011/137472
- US-A- 4 259 119
- US-A- 4 546 089

## Beschreibung

Die vorliegende Erfindung betrifft ein Target (eine Beschichtungsquelle) für die physikalische Dampfphasenabscheidung mit den Merkmalen des Oberbegriffs des Anspruchs 1 und ein Verfahren zur Herstellung eines Targets mit den Merkmalen des Anspruchs 9.

Im Stand der Technik werden in großem Umfang Verfahren der physikalischen Dampfphasenabscheidung zur Herstellung verschiedenster Schichten eingesetzt. Aufgrund des breiten Anwendungsspektrums solcher Schichten müssen verschiedenartige Beschichtungsmaterialien abgeschieden werden können.

Bei der physikalischen Dampfphasenabscheidung kommen dabei verschiedene Techniken zum Einsatz, wie z. B. Verdampfen, Kathodenzerstäubung (sputter deposition) oder Lichtbogenverdampfung (cathodic arc deposition oder Arc-Source-Verdampfungstechnik).

Ein Target ist für die Verwendung in einem PVD (physical vapor deposition, physikalische Dampfabscheidung) Prozess zur Abscheidung von Schichten auf ein dafür vorgesehenes Substratmaterial geeignet. Im Sinne der Erfindung sind unter dem Begriff Target Sputtertargets oder Arc Kathoden zu verstehen.

Die Targets werden je nach Werkstoff durch unterschiedliche Technologien hergestellt. Dabei kann man grundsätzlich zwischen pulver- und schmelzmetallurgischen Prozessen unterscheiden. Bei den pulvermetallurgischen Technologien gibt es viele unterschiedliche Möglichkeiten, die entsprechend der Zusammensetzung des Targets unter Berücksichtigung der Eigenschaften der integrierten Elemente gewählt werden müssen. Beispielhaft sind hier Pressen, Sintern, Heißisostatisches Pressen (HIP), Schmieden, Walzen, Heißpressen (HP) oder Spark Plasma Sintern (SPS) auch in Kombination untereinander zu nennen.

Gattungsgemäße Targets und Verfahren werden beschrieben in WO 2008/96648 A1, JP 05195199, JP55128560 und WO 2011/137472 A1. Weitere Targets und Verfahren sind aus EP 0 577 246 A1, US 2013/220800 A1 und US 4 430 184 A bekannt.

Insbesondere beschreibt die JP55128560 die Herstellung eines Sinterkörpers mit mindestens zwei unterschiedlichen Diboriden, wobei zwingend Metalle wie Nickel, Eisen und Kobalt in Form von Bonden als Binder und Sinterhilfsmittel verwendet werden, um den Nachteil der niedrigen Porosität der Herstellung bei verhältnismäßig niedrigen Sintertemperaturen zu kompensieren. Nachteilig ist, dass diese Metalle bei Einsatz eines Sinterkörpers als Targets die Reinheit der abgeschiedenen Schichten beeinträchtigen.

Es ist auch bekannt, Schichten aus Titandiborid (TiB₂) und Vanadiumdiborid (VB₂) mittels Co-Sputtern herzustellen, wobei gesonderte Targets aus im Wesentlichen reinen Titandiborid (TiB₂) und im Wesentlichen reinen Vanadiumdiborid (VB₂) eingesetzt werden. Nachteilig ist, dass bei industriellen Beschichtungsprozessen aufgrund der räumlichen Trennung der gesonderten Targets mit rotierenden Substraten zwangsläufig Multilagenschichten entstehen und keine chemisch homogene Schicht.

Aufgabe der Erfindung ist die Bereitstellung eines gattungsgemäßen Targets und eines gattungsgemäßen Verfahrens zur Herstellung eines Targets, welches eine hohe Dichte aufweist, mit welchem hochreine, chemisch homogene Schichten herstellbar sind und welches eine feinkörnige und isotrope Mikrostruktur aufweist.

Diese Aufgabe wird durch ein Target mit den Merkmalen des Anspruchs 1 und ein Verfahren mit den Merkmalen des Anspruchs 9 gelöst. Vorteilhafte Ausführungsformen der Erfindung sind in den abhängigen Ansprüchen definiert. Schutz wird auch begehrt für eine Verwendung eines erfindungsgemäßen Targets in einem physikalischen Gasphasen-Abscheide-Verfahren (PVD) zur Abscheidung von Dünnschichten auf einem Substrat.

Die Erfindung kommt ohne den Einsatz von Bindern oder Sinterhilfsmitteln wie beispielsweise Nickel, Kobalt oder Eisen als pulverförmige Zugaben aus, weil das erfindungsgemäße Verfahren zur Herstellung eines Targets bei verhältnismäßig hohen Temperaturen stattfindet. Dies führt aber zwangsläufig dazu, dass das Gefüge bei diesen hohen Temperaturen sehr stark vergröbern würde, was wiederum nachteilig für den Einsatz als Target wäre. Die Erfindung vermeidet diese Vergröberung, indem ein Pulver aus mindestens zwei unterschiedlichen Phasen, nämlich Titandiborid (TiB₂), Vanadiumdiborid (VB₂), und ggf. Kohlenstoff, vorzugsweise Graphit, (falls der Kohlenstoff nicht in Form einer Verunreinigung einer oder beider der Phasen Titandiborid (TiB₂) oder Vanadiumdiborid (VB₂) vorliegt), zum Einsatz kommt. Dies gewährleistet die Beibehaltung einer feinkörnigen Mikrostruktur trotz der verhältnismäßig hohen Verdichtungstemperatur.

Erfindungsgemäß beträgt die Summe aus der Mischung von wenigstens zwei der nachstehenden Verbindungen: Titandiborid (TiB₂) und/oder Vanadiumdiborid (VB₂) und/oder der sich beim Sintern ausbildenden Mischphasen ((Ti,V)B₂) von Titandiborid (TiB₂) und Vanadiumdiborid (VB₂) und dem Kohlenstoff (C) wenigstens 99,8 mol%. Dabei handelt es sich um die metallische Reinheit ohne Betrachtung solcher Elemente wie Sauerstoff (O), Stickstoff (N) oder Wasserstoff (H).

Ein für das erfindungsgemäße Verfahren verwendbarer Pulveransatz besteht aus:
- wenigstens 95 mol% aus einer Mischung von Titandiborid (TiB₂) und Vanadiumdiborid (VB₂)
- und gegebenenfalls 0,01 mol% bis 5 mol% Kohlenstoff (C)

Aufgrund von Verunreinigungen von Titandiborid (TiB₂) und/oder Vanadiumdiborid (VB₂) können in den erfindungsgemäßen Targets andere Boride als Titandiborid (TiB₂) und Vanadiumdiborid (VB₂) detektierbar sein (weniger als 0,01 mol%).

Bei einem Ausführungsbeispiel der Erfindung ist vorgesehen, dass der Kohlenstoff (C) in Form von Graphit vorliegt.

Für eine Mischung eines Pulveransatzes für alle nachstehend diskutierten erfindungsgemäßen Targets sind beispielhaft folgende Pulver verwendet worden:
- TiB₂ mit einem d50 Wert für die Korngröße von 2,4 µm
- VB₂ mit einem d50 Wert für die Korngröße von 7,0 µm
- Graphitpulver mit einer Korngröße kleiner 6 µm

Die Pulver sind in einem Verhältnis von TiB₂/VB₂/C von 74/24/2 mol% gemischt und in einem Mahlaggregat mit Mahlkugeln gemahlen worden. Die fertig gemahlene Pulvermischung ist durch Heißpressen bei einem Pressdruck von 30 MPa und einer Temperatur von 2000 °C verdichtet worden.

Bei einem Ausführungsbeispiel der Erfindung ist vorgesehen, dass das Titandiborid (TiB₂) und das Vanadiumdiborid (VB₂) derart homogen verteilt im Target vorliegen, dass bei Auswahl von zumindest fünf quadratischen oder kreisförmigen unterschiedlichen Messbereichen mit einer Größe von jeweils mindestens 1 mm² die an der Oberfläche des jeweiligen Messbereichs ermittelte mittlere chemische Zusammensetzung nicht mehr als 20 %, bevorzugt nicht mehr als 10 %, von einer gemittelten chemischen Zusammensetzung, berechnet aus allen ausgewählten Messbereichen, abweicht.

Drei solcher Messreihen für unterschiedliche erfindungsgemäße Targets sind in der nachfolgenden Tabelle dargestellt:

| EDX | TiB₂/VB₂ | | TiB₂/VB₂ | | TiB₂/VB₂ | |
|---|---|---|---|---|---|---|
| | 75/25 mol% | | 87,5/12,5 mol% | | 93,75/6,25 mol% | |
| Messung | Ti at% | V at% | Ti at% | V at% | Ti at% | V at% |
| 1 | 76,6 | 23,4 | 88,4 | 11,6 | 94,1 | 6,0 |
| 2 | 74,8 | 25,2 | 88,9 | 11,1 | 94,3 | 5,7 |
| 3 | 75,6 | 24,4 | 88,3 | 11,7 | 93,9 | 6,1 |
| 4 | 76,6 | 23,4 | 88,7 | 11,3 | 92,9 | 7,1 |
| 5 | 76,8 | 23,2 | 88,9 | 11,2 | 94,0 | 6,0 |
| **x** | **76,1** | **23,9** | **88,6** | **11,4** | **93,8** | **6,2** |

Gut erkennbar ist, dass die an der Oberfläche des jeweiligen Messbereichs ermittelte mittlere chemische Zusammensetzung für jedes der Targets nur minimal von der gemittelten chemischen Zusammensetzung, berechnet aus allen ausgewählten Messbereichen, abweicht.

Bei einem Ausführungsbeispiel der Erfindung ist vorgesehen, dass in einer röntgenografischen Untersuchung des Targets eine isotrope Struktur ohne bevorzugte kristallografische Kornausrichtung erkennbar ist, wobei ein Aspektverhältnis von Körnern der Mischung aus Titandiborid (TiB₂) und/oder Vanadiumdiborid (VB₂) und/oder Mischphasen ((Ti,V)B₂) von Titandiborid (TiB₂) und Vanadiumdiborid (VB₂) kleiner als 1,5, bevorzugt kleiner als 1,2, besonders bevorzugt im Wesentlichen 1, ist.

Bei einem Ausführungsbeispiel der Erfindung ist vorgesehen, dass nur Titandiborid (TiB₂) und/oder Vanadiumdiborid (VB₂) und/oder Mischphasen ((Ti,V)B₂) von Titandiborid (TiB₂) und Vanadiumdiborid (VB₂) in Form von röntgenografisch identifizierbaren Phasen vorliegen.

In Bezug auf das Verfahren ist bei einem Ausführungsbeispiel der Erfindung vorgesehen, dass das Heißpressen oder Spark-Plasma-Sintern (SPS) bei einem Druck von mindestens 20 MPa, bevorzugt mindestens 30 MPa erfolgt.

Beispiel aus der Fertigung über Heißpressen:
- TiB₂/VB₂ 75/25 mol% Pulvermischung gefertigt über Mahlen in einer Kugelmühle
- Heißpressen in einem Werkzeug mit dem Format von 238 x 353 mm zu einer Platte mit den Abmessungen von 32 x 238 x 353 mm mit den folgenden Parametern:
   o 2000 °C
   o Kraft von 252 Tonnen, was dem Druck von 29,5 MPa entspricht
   o Haltezeit bei Sintertemperatur von 30 Minuten

Die erreichte Dichte der Platte liegt bei 4,54 g/cm³ und somit ca. 97,8 % der theoretischen Dichte für diesen Werkstoff von 4,64 g/cm³, berechnet über die Mischregel für 75 mol% TiB₂ mit der theoretischen Dichte von 4,5 g/cm³ und 25 mol% VB₂ mit der theoretischen Dichte von 5,1 g/cm³.

In Bezug auf das Verfahren ist bei einem Ausführungsbeispiel der Erfindung vorgesehen, dass das Heißpressen oder Spark-Plasma-Sintern (SPS) in einem Vakuum oder in einer inerten Schutzgasatmosphäre erfolgt.

Die in dieser Offenbarung beschriebene Mikrostruktur des Targets aus TiB₂/VB₂-Mischungen ist für den Fachmann sowohl in Bezug auf Korngröße, Dichte, Dotierungen, Reinheit als auch das Herstellungsverfahren über Heißpressen oder SPS auf andere Kombinationen aus Boriden übertragbar, insbesondere auf Kombinationen aus den Boriden TiB₂, VB₂, CrB₂, ZrB₂, NbB₂, MoB₂, MoB, HfB₂, TaB₂, WB₂, W₂B₅. Bei den Mischungen geht es um Systeme aus wenigstens zwei Boriden, z. B. binäre Systeme aus zwei Boriden oder auch Systeme aus drei, vier oder noch mehr Boriden gleichzeitig in einer Mischung.

Ausführungsbeispiele der Erfindung werden anhand der Figuren diskutiert. Dabei zeigen:
- Fig. 1: eine REM (Rasterelektronenmikroskop)-Aufnahme eines nicht erfindungsgemäßen Targets aus reinem TiB₂
- Fig. 2: eine REM-Aufnahme eines weiteren nicht erfindungsgemäßen Targets aus reinem TiB₂
- Fig. 3a,b: REM-Aufnahmen zweier erfindungsgemäßer Targets aus TiB₂/VB₂
- Fig. 4: eine REM-Aufnahme eines erfindungsgemäßen Targets aus TiB₂/VB₂
- Fig. 5: eine REM-Aufnahme eines erfindungsgemäßen Targets aus TiB₂/VB₂
- Fig. 6: eine REM-Aufnahme eines erfindungsgemäßen Targets aus TiB₂/VB₂
- Fig. 7a,b: eine röntgenografische Aufnahme (XRD) eines erfindungsgemäßen Targets nach Fig. 3b sowie ein vergrößerter Ausschnitt der röntgenografischen Aufnahme (XRD)
- Fig. 8: eine fotografische Aufnahme des Ergebnisses eines Härtetests bei einem erfindungsgemäßen Target aus TiB₂/VB₂ 75/25 mol%
- Fig. 9: eine fotografische Aufnahme des Ergebnisses eines Härtetests bei einem Target nach Fig. 4
- Fig. 10: eine fotografische Aufnahme des Ergebnisses eines Härtetests bei einem Target nach Fig. 5

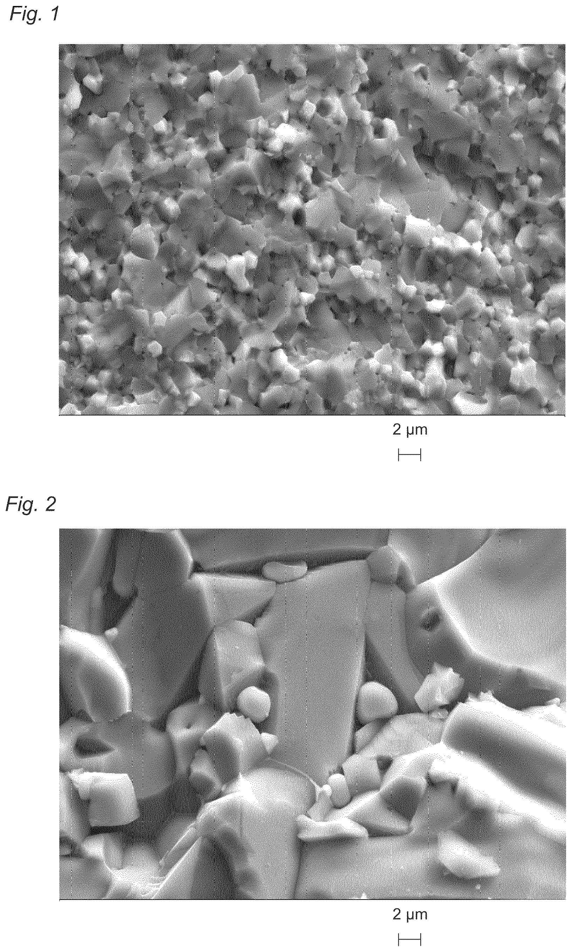

Fig. 1 und 2 zeigen Beispiele für ein Gefüge von reinem TiB₂-Werkstoff, der bei unterschiedlichen Temperaturen verdichtet wurde, um eine entsprechend hohe Dichte zu erreichen. Zum einfacheren Vergleich ist die Vergrößerung bei beiden Fig. identisch gewählt worden. Ist die Temperatur zu hoch, so erfolgt bereits eine starke Kornvergröberung.

Fig. 1 zeigt reines TiB₂, heißgepresst bei 1650 °C. Das Gefüge ist noch relativ feinkörnig mit einer abgeschätzten mittleren Korngröße von 2 µm als d50-Wert. Die Dichte des Werkstoffes beträgt 4,43 g/cm³ und somit ca. 98 % der theoretischen Dichte von 4,52 g/cm³ für TiB₂.

Fig. 2 zeigt reines TiB₂, heißgepresst bei 1700 °C. Das Gefüge ist bereits teilweise relativ stark vergröbert mit einzelnen Körnern größer als 10 µm. Die Dichte des Werkstoffes beträgt ca. 98,5 % der theoretischen Dichte von TiB₂.

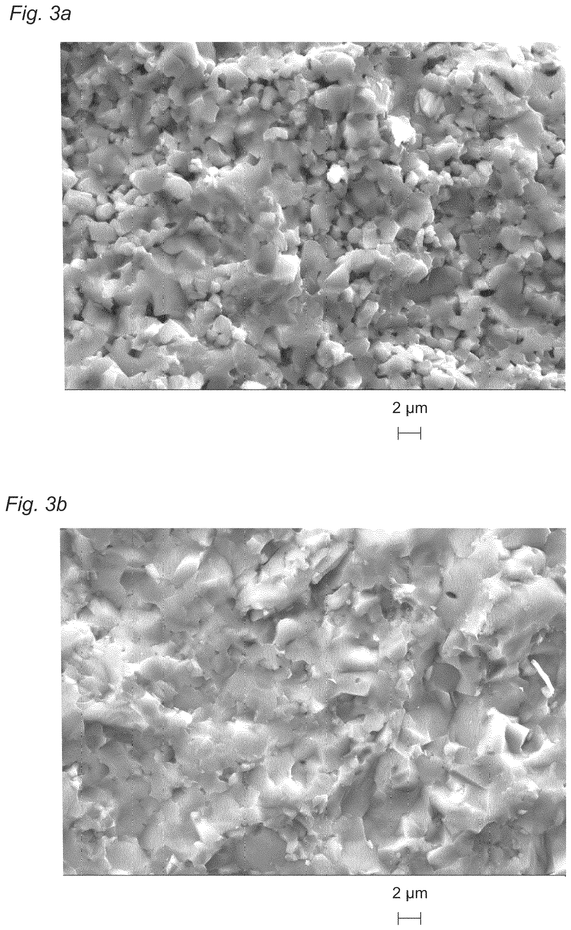

Fig. 3 bis 5 zeigen Beispiele für erfindungsgemäße Targets, bei welchen das molekulare Verhältnis von Titan (Ti) zu Vanadium (V) in der Mischung von Titandiborid (TiB₂) und/oder Vanadiumdiborid (VB₂) und/oder Mischphasen ((Ti,V)B₂) von Titandiborid (TiB₂) und Vanadiumdiborid (VB₂) in einem Bereich von 1:99 bis 99:1, bevorzugt in einem Bereich von 10:90 bis 90:10, liegt. Das Gefüge der TiB₂/VB₂-Werkstoffe in den Fig. 3 bis 5 zeigt keinerlei Texturierung und ein isotropes Gefüge mit einem Aspektverhältnis der Körner im Wesentlichen von 1.

Fig. 3a zeigt ein Detail eines Targets aus einem TiB₂/VB₂ 75/25 mol% Werkstoff, verdichtet über SPS bei 1900 °C. Die Dichte des Werkstoffes beträgt 4,19 g/cm³ und somit ca. 90 % der theoretischen Dichte für diesen Werkstoff von 4,64 g/cm³, berechnet über die Mischregel für 75 mol% TiB₂ mit der theoretischen Dichte von 4,5 g/cm³ und 25 mol% VB₂ mit der theoretischen Dichte von 5,1 g/cm³.

Fig. 3b zeigt ein Detail eines Targets aus einem TiB₂/VB₂ 75/25 mol% Werkstoff, verdichtet über SPS bei 2000 °C. Die Dichte des Werkstoffes beträgt 4,49 g/cm³ und somit ca. 97 % der theoretischen Dichte für diesen Werkstoff von 4,64 g/cm³, berechnet über die Mischregel für 75 mol% TiB₂ mit der theoretischen Dichte von 4,5 g/cm³ und 25 mol% VB₂ mit der theoretischen Dichte von 5,1 g/cm³.

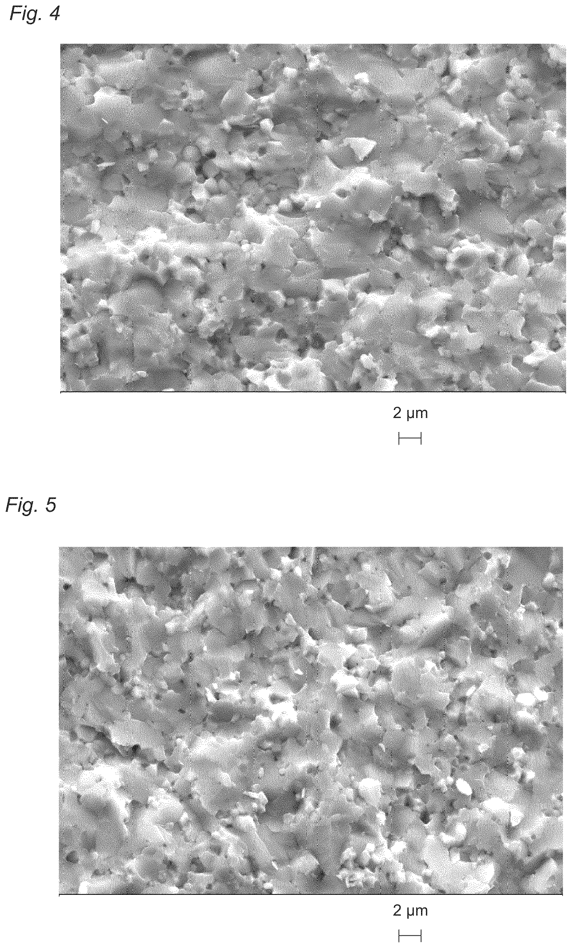

Fig. 4 zeigt ein Detail eines Targets aus einem TiB₂/VB₂ 87,5/12,5 mol% Werkstoff, verdichtet über SPS bei 2000 °C. Die Dichte des Werkstoffes beträgt 4,52 g/cm³ und somit ca. 99 % der theoretischen Dichte für diesen Werkstoff von 4,57 g/cm³, berechnet über die Mischregel für 87,5 mol% TiB₂ mit der theoretischen Dichte von 4,5 g/cm³ und 12,5 mol% VB₂ mit der theoretischen Dichte von 5,1 g/cm³.

Fig. 5 zeigt einen TiB₂/VB₂ 93,75/6,25 mol% Werkstoff verdichtet über SPS bei 2000 °C. Die Dichte des Werkstoffes beträgt 4,46 g/cm³ und somit ca. 98 % der theoretischen Dichte für diesen Werkstoff von 4,53 g/cm³, berechnet über die Mischregel für 93,75 mol% TiB₂ mit der theoretischen Dichte von 4,5 g/cm³ und 6,25 mol% VB₂ mit der theoretischen Dichte von 5,1 g/cm³.

Die oben beschriebenen erfindungsgemäßen Targets wurden durch das SPS Verfahren hergestellt, welches jeweils im Vakuum durchgeführt worden ist.

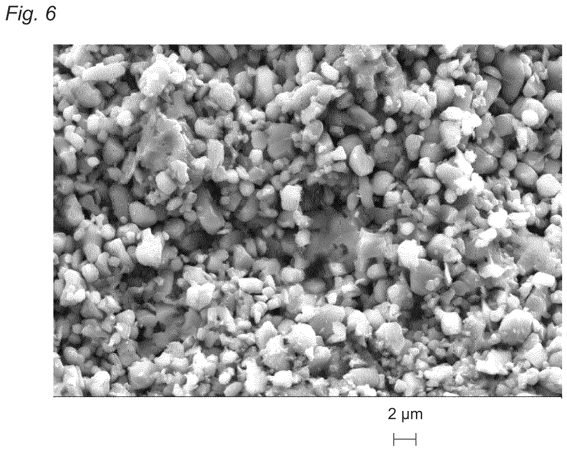

Fig. 6 zeigt zum Vergleich ein Gefüge mit immer noch hoher Porosität, weil bei der niedrigsten akzeptablen Temperatur verdichtet, nämlich einen TiB₂/VB₂ 75/25 mol% Werkstoff verdichtet über SPS bei 1750 °C. Die Dichte des Werkstoffes beträgt 4,01 g/cm³ und somit ca. 86 % der theoretischen Dichte für diesen Werkstoff von 4,64 g/cm³, berechnet über die Mischregel für 75 mol% TiB₂ mit der theoretischen Dichte von 4,5 g/cm³ und 25 mol% VB₂ mit der theoretischen Dichte von 5,1 g/cm³.

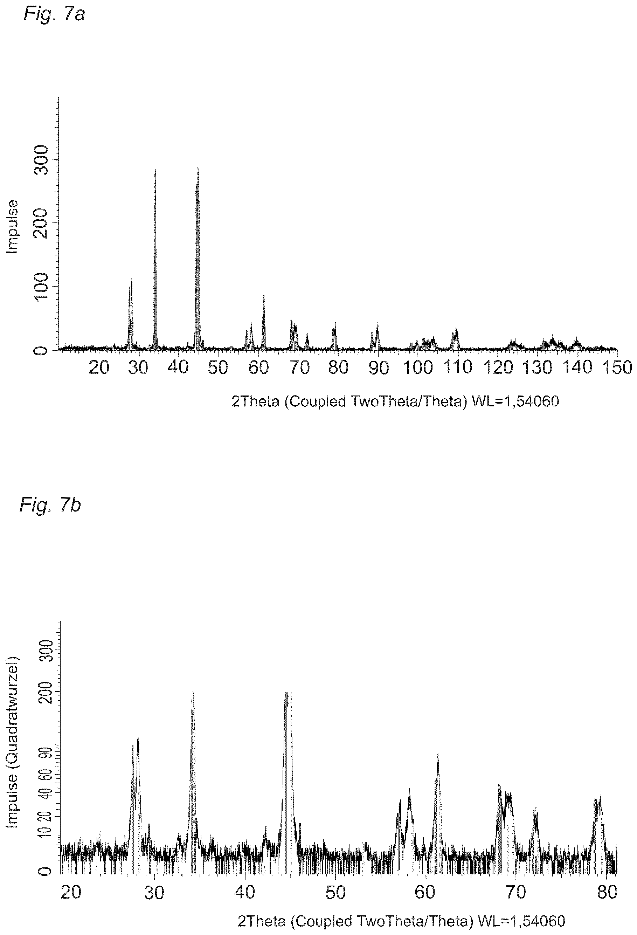

In den Fig. 7a und 7b ist ein röntgenographisch ermitteltes Spektrum zur Phasenanalyse am Target mit der Zusammensetzung nach Fig. 3b zu sehen. Von Interesse sind Reflexe charakteristisch für die Phasen TiB₂, (Ti,V)B₂ und VB₂. Hauptsächlich sind diese drei Phasen TiB₂, (Ti,V)B₂ und VB₂ diesem Spektrum durch einen Fachmann zuordenbar.

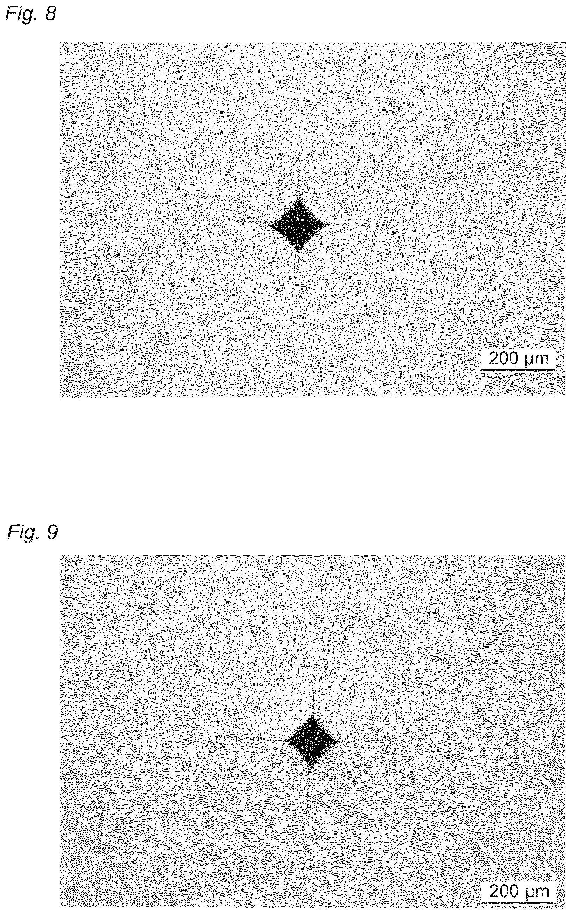

Die Figuren 8 bis 10 zeigen jeweils beispielhaft einen HV30-Härteeindruck, gemessen an den TiB₂/VB₂ Mischtargets. Für eine repräsentative Aussage zur Härte wurden hier jeweils drei HV30-Härteeindrücke zugrunde gelegt.

Fig. 8 zeigt einen von drei HV30-Härteeindrücken bei einem Target aus TiB₂/VB₂ 75/25 mol%.

Fig. 9 zeigt einen von drei HV30-Härteeindrücken bei einem Target aus TiB₂/VB₂ 87,5/12,5 mol%.

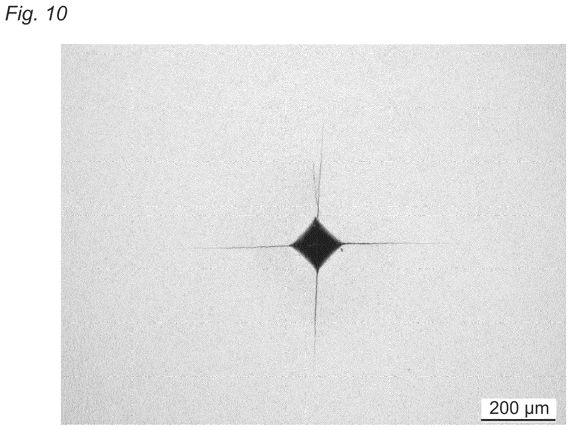

Fig. 10 zeigt einen von drei HV30-Härteeindrücken bei einem Target aus TiB₂/VB₂ 93,75/6,25 mol%.

Die Messergebnisse sind in der nachfolgenden Tabelle zusammengefasst:

| Eindruck | TiB₂/VB₂ 75/25 mol% | TiB₂/VB₂ 87,5/12,5 mol% | TiB₂/VB₂ 93,75/6,25 mol% |
|---|---|---|---|
| Nr.1 | 2270 | 2257 | 2414 |
| Nr.2 | 2302 | 2487 | 2373 |
| Nr.3 | 2238 | 2393 | 2443 |
| **x** | **2270 HV30** | **2379 HV30** | **2410 HV30** |

## Patentansprüche

1. Target für die physikalische Dampfphasenabscheidung, mit folgender chemischer Zusammensetzung:
- wenigstens 95 mol% aus einer Mischung von wenigstens zwei der nachstehenden Verbindungen: Titandiborid (TiB₂) und/oder Vanadiumdiborid (VB₂) und/oder Mischphasen ((Ti,V)B₂) von Titandiborid (TiB₂) und Vanadiumdiborid (VB₂)
- 0,01 mol% bis 5 mol% Kohlenstoff (C)
- weniger als 0,01 mol% andere Boride als Titandiborid (TiB₂) und/oder Vanadiumdiborid (VB₂) und/oder Mischphasen ((Ti,V)B₂) von Titandiborid (TiB₂) und Vanadiumdiborid (VB₂)
wobei in Bezug auf die metallische Reinheit die Summe aus der Mischung von Titandiborid (TiB₂) und/oder Vanadiumdiborid (VB₂) und/oder Mischphasen ((Ti,V)B₂) von Titandiborid (TiB₂) und Vanadiumdiborid (VB₂) und dem Kohlenstoff (C) wenigstens 99,8 mol% beträgt,
und mit folgenden physikalischen Eigenschaften:
- einer Dichte größer als 90 %, vorzugsweise größer als 95 %, der theoretischen Dichte der oben definierten chemischen Zusammensetzung
- einem d50-Wert als mittlere Korngröße von Körnern der Mischung von Titandiborid (TiB₂) und/oder Vanadiumdiborid (VB₂) und/oder Mischphasen ((Ti,V)B₂) von Titandiborid (TiB₂) und Vanadiumdiborid (VB₂) kleiner als 10 µm, vorzugsweise kleiner 3 µm.

2. Target nach Anspruch 1, wobei das molekulare Verhältnis von Titan (Ti) zu Vanadium (V) in der Mischung von Titandiborid (TiB₂) und/oder Vanadiumdiborid (VB₂) und/oder Mischphasen ((Ti,V)B₂) von Titandiborid (TiB₂) und Vanadiumdiborid (VB₂) in einem Bereich liegt von 1:99 bis 99:1, bevorzugt in einem Bereich von 10:90 bis 90:10.

3. Target nach wenigstens einem der vorangehenden Ansprüche, wobei der Kohlenstoff (C) in Form von Graphit vorliegt.

4. Target nach wenigstens einem der vorangehenden Ansprüche, wobei nur Titandiborid (TiB₂) und/oder Vanadiumdiborid (VB₂) und/oder Mischphasen ((Ti,V)B₂) von Titandiborid (TiB₂) und Vanadiumdiborid (VB₂) in Form von röntgenografisch identifizierbaren Phasen vorliegen.

5. Target nach wenigstens einem der vorangehenden Ansprüche, wobei das Titandiborid (TiB₂) und/oder das Vanadiumdiborid (VB₂) und/oder Mischphasen ((Ti,V)B₂) von Titandiborid (TiB₂) und Vanadiumdiborid (VB₂) derart homogen verteilt im Target vorliegen, dass bei Auswahl von zumindest fünf quadratischen oder kreisförmigen unterschiedlichen Messbereichen mit einer Größe von jeweils mindestens 1 mm² die an der Oberfläche des jeweiligen Messbereichs ermittelte mittlere chemische Zusammensetzung nicht mehr als 20 %, bevorzugt nicht mehr als 10 %, von einer gemittelten chemischen Zusammensetzung, berechnet aus allen ausgewählten Messbereichen, abweicht.

6. Target nach wenigstens einem der vorangehenden Ansprüche, wobei in einer röntgenografischen Untersuchung des Targets eine isotrope Struktur ohne bevorzugte kristallografische Kornausrichtung erkennbar ist, wobei ein Aspektverhältnis von Körnern aus Titandiborid (TiB₂) und/oder Vanadiumdiborid (VB₂) und/oder Mischphasen ((Ti,V)B₂) von Titandiborid (TiB₂) und Vanadiumdiborid (VB₂) kleiner als 1,5, bevorzugt kleiner als 1,2, besonders bevorzugt im Wesentlichen 1, ist.

7. Target nach wenigstens einem der vorangehenden Ansprüche, wobei gegebenenfalls vorliegende andere chemische Elemente als Titan (Ti), Vanadium (V), Bor (B) und Kohlenstoff (C) im Gefüge der Mischung von Titandiborid (TiB₂) und/oder Vanadiumdiborid (VB₂) und/oder Mischphasen ((Ti,V)B₂) von Titandiborid (TiB₂) und Vanadiumdiborid (VB₂) gelöst sind und nicht als gesonderte Phasen röntgenografisch detektierbar sind.

8. Target nach wenigstens einem der vorangehenden Ansprüche, wobei eine HV30 Vickershärte des Targets größer als 1500 HV30, bevorzugt größer als 2000 HV30 ist.

9. Verfahren zur Herstellung eines Targets für die physikalische Dampfphasenabscheidung, insbesondere eines Targets nach wenigstens einem der vorangehenden Ansprüche, wobei in Form eines Pulvers vorliegendes Titandiborid (TiB₂) und in Form eines Pulvers vorliegendes Vanadiumdiborid (VB₂) - sowie gegebenenfalls pulverförmiger Kohlenstoff, falls dieser nicht als Verunreinigung vorliegt - gemischt und gegebenenfalls mechanisch gemahlen werden und der so hergestellte Pulveransatz in einem formgebenden Werkzeug mittels Heißpressen oder Spark-Plasma-Sintern (SPS) verdichtet wird, **dadurch gekennzeichnet, dass**
der Pulveransatz besteht aus:
- wenigstens 95 mol% aus einer Mischung von Titandiborid (TiB₂) und Vanadiumdiborid (VB₂)
- und 0,01 mol% bis 5 mol% Kohlenstoff (C)
wobei in Bezug auf die metallische Reinheit die Summe aus der Mischung von Titandiborid (TiB₂) und Vanadiumdiborid (VB₂) und dem Kohlenstoff (C) wenigstens 99,8 mol% beträgt,
und dass das Heißpressen oder Spark-Plasma-Sintern (SPS) mit einer Temperatur von mindestens 1750 °C, bevorzugt mindestens 1850 °C, besonders bevorzugt mindestens 1950 °C erfolgt.

10. Verfahren nach dem vorangehenden Anspruch, wobei das Heißpressen oder Spark-Plasma-Sintern (SPS) bei einem Druck von mindestens 20 MPa, bevorzugt mindestens 30 MPa erfolgt.

11. Verfahren nach wenigstens einem der vorangehenden Ansprüche, wobei das Heißpressen oder Spark-Plasma-Sintern (SPS) in einem Vakuum oder in einer inerten Schutzgasatmosphäre erfolgt.

12. Verwendung eines Targets nach wenigstens einem der Ansprüche 1 bis 8 in einem physikalischen Gasphasen-Abscheide-Verfahren (PVD) zur Abscheidung von Dünnschichten auf einem Substrat.

## Claims

1. Target for physical vapour deposition with the following chemical composition:
- at least 95 mol% of a mixture of at least two of the following compounds: titanium diboride (TiB₂) and/or vanadium diboride (VB₂) and/or mixed phases ((Ti,V)B₂) of titanium diboride (TiB₂) and vanadium diboride (VB₂)
- 0.01 mol% to 5 mol% of carbon (C)
- less than 0.01 mol% of borides other than titanium diboride (TiB₂) and/or vanadium diboride (VB₂) and/or mixed phases ((Ti,V)B₂) of titanium diboride (TiB₂) and vanadium diboride (VB₂)
wherein, in relation to metallic purity, the sum of the mixture of titanium diboride (TiB₂) and/or vanadium diboride (VB₂) and/or mixed phases ((Ti,V)B₂) of titanium diboride (TiB₂) and vanadium diboride (VB₂) and the carbon (C) is at least 99.8 mol%,
and with the following physical properties:
- a density greater than 90%, preferably greater than 95%, of the theoretical density of the chemical composition defined above
- a d50 value, as the average grain size, of grains of the mixture of titanium diboride (TiB₂) and/or vanadium diboride (VB₂) and/or mixed phases ((Ti,V)B₂) of titanium diboride (TiB₂) and vanadium diboride (VB₂), of less than 10 µm, preferably less than 3 µm.

2. Target according to claim 1, wherein the molecular ratio of titanium (Ti) to vanadium (V) in the mixture of titanium diboride (TiB₂) and/or vanadium diboride (VB₂) and/or mixed phases ((Ti,V)B₂) of titanium diboride (TiB₂) and vanadium diboride (VB₂) lies in a range of from 1:99 to 99:1, preferably in a range of from 10:90 to 90:10.

3. Target according to at least one of the preceding claims, wherein the carbon (C) is present in the form of graphite.

4. Target according to at least one of the preceding claims, wherein only titanium diboride (TiB₂) and/or vanadium diboride (VB₂) and/or mixed phases ((Ti,V)B₂) of titanium diboride (TiB₂) and vanadium diboride (VB₂) are present in the form of radiographically identifiable phases.

5. Target according to at least one of the preceding claims, wherein the titanium diboride (TiB₂) and/or the vanadium diboride (VB₂) and/or mixed phases ((Ti,V)B₂) of titanium diboride (TiB₂) and vanadium diboride (VB₂) are present homogeneously distributed in the target such that, if at least five different square or circular measurement areas, with a size of at least 1 mm² in each case, are selected, the average chemical composition determined on the surface of the respective measurement area does not deviate by more than 20%, preferably not by more than 10%, from an averaged chemical composition calculated from all of the selected measurement areas.

6. Target according to at least one of the preceding claims, wherein an isotropic structure without preferred crystallographic grain orientation is recognizable in a radiographic examination of the target, wherein an aspect ratio of grains of titanium diboride (TiB₂) and/or vanadium diboride (VB₂) and/or mixed phases ((Ti,V)B₂) of titanium diboride (TiB₂) and vanadium diboride (VB₂) is less than 1.5, preferably less than 1.2, particularly preferably substantially 1.

7. Target according to at least one of the preceding claims, wherein possibly present chemical elements other than titanium (Ti), vanadium (V), boron (B) and carbon (C) are dissolved in the structure of the mixture of titanium diboride (TiB₂) and/or vanadium diboride (VB₂) and/or mixed phases ((Ti,V)B₂) of titanium diboride (TiB₂) and vanadium diboride (VB₂) and are not radiographically detectable as separate phases.

8. Target according to at least one of the preceding claims, wherein an HV30 Vickers hardness of the target is greater than 1500 HV30, preferably greater than 2000 HV30.

9. Method for producing a target for physical vapour deposition, in particular a target according to at least one of the preceding claims, wherein titanium diboride (TiB₂) present in the form of a powder and vanadium diboride (VB₂) present in the form of a powder - as well as, where appropriate, pulverulent carbon, unless it is present as an impurity - are mixed and, where appropriate, mechanically ground, and the thus-produced batch of powder is compacted in a shaping die by means of hot pressing or spark plasma sintering (SPS), **characterized in that**
the batch of powder consists of:
- at least 95 mol% of a mixture of titanium diboride (TiB₂) and vanadium diboride (VB₂)
- and 0.01 mol% to 5 mol% of carbon (C)
wherein, in relation to metallic purity, the sum of the mixture of titanium diboride (TiB₂) and vanadium diboride (VB₂) and the carbon (C) is at least 99.8 mol%,
and **in that** the hot pressing or spark plasma sintering (SPS) is effected at a temperature of at least 1750°C, preferably at least 1850°C, particularly preferably at least 1950°C.

10. Method according to the preceding claim, wherein the hot pressing or spark plasma sintering (SPS) is effected at a pressure of at least 20 MPa, preferably at least 30 MPa.

11. Method according to at least one of the preceding claims, wherein the hot pressing or spark plasma sintering (SPS) is effected in a vacuum or in an inert protective atmosphere.

12. Use of a target according to at least one of claims 1 to 8 in a physical vapour deposition (PVD) process for depositing thin films on a substrate.

## Revendications

1. Cible pour le dépôt physique en phase vapeur, avec la composition chimique suivante :
- au moins 95 % en moles d'un mélange d'au moins deux des composés suivants : diborure de titane (TiB₂) et/ou diborure de vanadium (VB₂) et/ou phases mixtes ((Ti, V(B₂) de diborure de titane (TiB₂) et diborure de vanadium (VB₂)
- 0,01 % en moles à 5 % en moles de carbone (C)
- moins de 0,01 % en moles d'autres borures que le diborure de titane (TiB₂) et/ou diborure de vanadium (VB₂) et/ou des phases mixtes ((Ti, V)B₂) de diborure de titane (TiB₂) et diborure de vanadium (VB₂)
dans laquelle en ce qui concerne la pureté métallique la somme du mélange de diborure de titane (TiB₂) et/ou diborure de vanadium (VB₂) et/ou des phases mixtes ((Ti, V)B₂) de diborure de titane (TiB₂) et diborure de vanadium (VB₂) et du carbone (C) atteint au moins 99,8 % en moles, et avec les propriétés physiques suivantes :
- une masse volumique supérieure à 90 %, de préférence supérieure à 95 %, de la masse volumique théorique de la composition chimique définie ci-dessus
- une valeur D50 comme granulométrie moyenne de grains du mélange de diborure de titane (TiB₂) et/ou diborure de vanadium (VB₂) et/ou des phases mixtes ((Ti, V)B₂) de diborure de titane (TiB₂) et diborure de vanadium (VB₂) inférieure à 10 µm, de préférence inférieure à 3 µm.

2. Cible selon la revendication 1, dans laquelle le rapport moléculaire du titane (Ti) au vanadium (V) dans le mélange de diborure de titane (TiB₂) et/ou diborure de vanadium (VB₂) et/ou des phases mixtes ((Ti, V)B₂) de diborure de titane (TiB₂) et diborure de vanadium (VB₂) se situe dans une plage de 1:99 à 99:1, de préférence dans une plage de 10:90 à 90:10.

3. Cible selon au moins l'une des revendications précédentes, dans laquelle le carbone (C) est présent sous forme de graphite.

4. Cible selon au moins l'une des revendications précédentes, dans laquelle seuls le diborure de titane (TiB₂) et/ou diborure de vanadium (VB₂) et/ou les phases mixtes ((Ti, V)B₂) de diborure de titane (TiB₂) et diborure de vanadium (VB₂) sont présents sous forme de phases identifiables de manière radiographique.

5. Cible selon au moins l'une des revendications précédentes, dans laquelle le diborure de titane (TiB₂) et/ou le diborure de vanadium (VB₂) et/ou les phases mixtes ((Ti, V)B₂) de diborure de titane (TiB₂) et diborure de vanadium (VB₂) sont présents dans la cible de manière répartie de façon homogène, de telle sorte que lors de la sélection d'au moins cinq zones de mesure carrées ou circulaires différentes avec une taille de respectivement au moins 1 mm² la composition chimique moyenne déterminée sur la surface de la zone de mesure respective ne diffère pas de plus de 20 %, de préférence pas de plus de 10 %, d'une composition chimique moyenne, calculée à partir de toutes les zones de mesure sélectionnées.

6. Cible selon au moins l'une des revendications précédentes, dans laquelle dans un examen radiographique de la cible une structure isotrope sans orientation des grains de préférence cristallographique peut être reconnue, dans laquelle un rapport d'aspect des grains de diborure de titane (TiB₂) et/ou diborure de vanadium (VB₂) et/ou phases mixtes ((Ti, V)B₂) de diborure de titane (TiB₂) et diborure de vanadium (VB₂) est inférieur à 1,5, de préférence inférieur à 1,2, de manière particulièrement préférée est sensiblement 1.

7. Cible selon au moins l'une des revendications précédentes, dans laquelle d'autres éléments chimiques que le titane (Ti), le vanadium (V), le bore (B) et le carbone (C) éventuellement présents sont dissous dans la texture du mélange de diborure de titane (TiB₂) et/ou diborure de vanadium (VB₂) et/ou phases mixtes ((Ti, V)B₂) de diborure de titane (TiB₂) et diborure de vanadium (VB₂) et ne peuvent pas être détectés de manière radiographique en tant que phases séparées.

8. Cible selon au moins l'une des revendications précédentes, dans laquelle une dureté Vickers HV30 de la cible est supérieure à 1500 HV30, de préférence supérieure à 2000 HV30.

9. Procédé pour la fabrication d'une cible pour le dépôt physique en phase vapeur, en particulier d'une cible selon au moins l'une des revendications précédentes, dans lequel le diborure de titane (TiB₂) présent sous forme d'une poudre et le diborure de vanadium (VB₂) présent sous forme d'une poudre - ainsi qu'éventuellement du carbone sous forme de poudre, au cas où celui-ci ne serait pas présent en tant qu'impureté
- sont mélangés et éventuellement broyés mécaniquement et l'ébauche de poudre ainsi fabriquée est comprimée dans un moule de façonnage au moyen d'un pressage à chaud ou frittage flash (SPS), **caractérisé en ce que** l'ébauche de poudre est constituée de :
- au moins 95 % en moles d'un mélange de diborure de titane (TiB₂) et diborure de vanadium (VB₂)
- et 0,01 % en moles à 5 % en moles de carbone (C)
dans lequel en ce qui concerne la pureté métallique la somme du mélange de diborure de titane (TiB₂) et de diborure de vanadium (VB₂) et du carbone (C) atteint au moins 99,8 % en moles,
et que le pressage à chaud ou frittage flash (SPS) s'effectue à une température d'au moins 1750 °C, de préférence au moins 1850 °C, de manière particulièrement préférée d'au moins 1950 °C.

10. Procédé selon la revendication précédente, dans lequel le pressage à chaud ou frittage flash (SPS) s'effectue à une pression d'au moins 20 MPa, de préférence au moins 30 MPa.

11. Procédé selon au moins l'une des revendications précédentes, dans lequel le pressage à chaud ou frittage flash (SPS) s'effectue dans un vide ou dans une atmosphère inerte de gaz protecteur.

12. Utilisation d'une cible selon au moins l'une des revendications 1 à 8 dans un procédé de dépôt physique en phase vapeur (PVD) pour le dépôt de couches minces sur un substrat.
